(19) Europäisches Patentamt
European Patent Office
Office européen des brevets

(11) Veröffentlichungsnummer: **0 303 069 B1**

(12) **EUROPÄISCHE PATENTSCHRIFT**

(45) Veröffentlichungstag der Patentschrift: **24.06.92**

(51) Int. Cl.$^5$: **C08G 18/64**, C08G 18/38, C08G 18/34, C08G 18/81, C08G 18/67, C08G 73/10, G03F 7/00, H05K 3/00

(21) Anmeldenummer: **88111457.3**

(22) Anmeldetag: **16.07.88**

Die Akte enthält technische Angaben, die nach dem Eingang der Anmeldung eingereicht wurden und die nicht in dieser Patentschrift enthalten sind.

(54) **Verfahren zur Herstellung oligomerer oder polymerer strahlungsreaktiver Vorstufen für lösungsmittel-strukturierte Schichten.**

(30) Priorität: **23.07.87 DE 3724368**

(43) Veröffentlichungstag der Anmeldung:
**15.02.89 Patentblatt 89/07**

(45) Bekanntmachung des Hinweises auf die Patenterteilung:
**24.06.92 Patentblatt 92/26**

(84) Benannte Vertragsstaaten:
**BE CH DE FR GB IT LI NL SE**

(56) Entgegenhaltungen:
**EP-A- 0 027 506**
**GB-A- 1 060 576**
**GB-A- 1 173 608**
**US-A- 3 814 776**
**US-A- 4 338 427**

(73) Patentinhaber: **BASF Aktiengesellschaft**
**Carl-Bosch-Strasse 38**
**W-6700 Ludwigshafen(DE)**

(72) Erfinder: **Blum, Rainer**
**Bannwasserstrasse 58**
**W-6700 Ludwigshafen(DE)**

EP 0 303 069 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft oligomere oder polymere strahlungsreaktive Vorstufen von Polyimiden, Polyisoindolochinazolindionen, Polyoxazindionen und Polychinazolindionen, Verfahren zur Herstellung dieser strahlungsreaktiven Vorstufen und deren Verwendung.

Es ist bekannt, strukturierte Schichten, insbesondere für elektronische Anwendungen, dadurch zu erzeugen, daß zunächst lösliche Vorstufen A, die strahlenvernetzbare Doppelbindungen enthalten, aus Lösungen auf das Substrat aufgetragen und unter milden Bedingungen getrocknet werden. Unter einer Maske wird dann mit Strahlen von geeigneter Wellenlänge eine vernetzte Zwischenstufe B gebildet. Mit geeigneten Lösemitteln werden sodann die unbelichteten, d.h. unvernetzten Stellen, die noch die Vorstufen A enthalten, ausgewaschen. Die aus der Zwischenstufe B resultierende Struktur wird dann durch Anwendung hoher Temperatur in die Endfunktionsstruktur der Stufe C überführt.

Es ist notwendig, in die Vorstufe A strahlungsempfindliche Gruppen, insbesondere ethylenische Doppelbindungen, einzuführen. Dieser Schritt ist Gegenstand zahlreicher Patente und wird beispielsweise in DE-A-2 308 830, DE-A-2 437 397, DE-A-2 437 348, DE-A-2 437 413, DE-A-2 437 369, DE-A-2 919 840, DE-A-2 919 841 und DE-A-2 933 826 beschrieben.

Vorstufen der genannten Art, die in organischen Lösungsmittel löslich sind, sind beispielsweise aus der DE-PS 23 08 830 bekannt. Die bekannten polymeren Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat-oder Hydroxylgruppen und teilweise in ortho- oder para-Stellung dazu esterartig an Carboxylgruppen gebundene strahlungsreaktive Gruppen und die mit diesen Verbindungen umzusetzenden Diamine, Diisocyanate, Bis-säurechloride und Dicarbonsäuren weisen mindestens ein cyclisches Strukturelement auf.

Strahlungsreaktive Polyimid-Vorstufen werden dabei insbesondere in der Weise hergestellt, daß ungesättigte Alkohole, wie Allylalkohol, an Tetracarbonsäuredianhydride, wie Pyromellithsäuredianhydrid, addiert, die freien Carbonsäuregruppen der dabei gebildeten Diester in Säurechloridgruppen übergeführt und die entstandenen Diester-bis-säurechloride einer Polykondensationsreaktion mit einem - meist aromatischen - Diamin, wie Diaminodiphenyläther, unterworfen werden. Bei der Verwendung von Diaminoverbindungen, die ortho-ständige Amidogruppen aufweisen, entstehen in entsprechender Weise Polyisoindolochinazolindione.

Polyoxazindion-Vorstufen entstehen durch Polyaddition von Diisocyanaten, wie Diphenylmethandiisocyanat, an phenolische Hydroxylgruppen olefinisch ungesättigter Diester, wie Methylen-disalicylsäureester, und - in entsprechender Weise - Polychinazolidione durch Polyaddition von Diisocyanaten an Aminogruppen olefinisch ungesättigter Diester.

Die bekannten Herstellungsverfahren erfordern im allgemeinen mehrere Reaktionsschritte und auch tiefe Temperaturen. Darüber hinaus ist einerseits bei der Verwendung von Säurechloriden eine intensive Reinigung der Reaktionsprodukte erforderlich, andererseits ist die Synthese von ungesättigten Diestern der genannten Art schwierig durchzuführen.

In DE-A-2 933 826 wird ein Weg aufgezeigt, durch Addition von ungesättigten Epoxiden an carboxylgruppentragende Vorstufen, einen Teil dieser Schwierigkeiten zu umgehen. Nachteilig ist dabei, daß Carboxylgruppen nur bei höherer Temperatur und mit Katalysatoren in befriedigender Geschwindigkeit mit Epoxidgruppen reagieren. Dies führt dazu, daß häufig unlösliche, z.B. durch Teilimidisierung, oder anvernetzte Produkte entstehen.

Aufgabe der Erfindung ist es, oligomere und/oder polymere Vorstufen von Polyimiden, Polyisoindolochinazolindionen, Polyoxazindionen und Polychinazolindionen breitzustellen, die in organischen Lösungsmitteln löslich, strahlungsreaktiv und in einfacher Weise herstellbar sind.

Aufgabe der vorliegenden Erfindung ist es auch, einen neuen Weg für die Einführung der Doppelbindungen in die Stufe A aufzuzeigen, der sich nicht nur auf technisch einfachere Weise durchführen läßt, sondern auch beim Übergang von Zwischenstufe B in die Endstufe C einen geringeren Massenverlust aufweist und dadurch zu besserer Strukturqualität führt.

Diese Aufgabe läßt sich überraschenderweise erfindungsgemäß durch Einführung der Doppelbindung über bestimmte Isocyanate bei der Herstellung der Stufe A erreichen.

Diese Aufgabe läßt sich insbesondere dadurch in technisch vorteilhafter Weise lösen, daß die Vorstufen (A) aus Additionsprodukten von bestimmten ethylenisch ungesättigten Monoisocyanaten an carboxylgruppenhaltige Polyadditionsprodukte (PA) aus aromatischen und/oder heterocyclischen Tetracarbonsäuredianhydriden und Diaminoverbindungen oder Diaminoverbindungen mit wenigsten einer orthoständigen Amidogruppe bzw. an carboxylgruppenhaltige Polyadditionsprodukte aus aromatischen und/oder heterocyclischen

Dihydroxydicarbonsäuren oder entsprechenden Diaminodicarbonsäuren und Diisocyanaten hergestellt werden.

Gegenstand der vorliegenden Erfindung ist ein Verfahren zur Herstellung oligomerer oder polymerer strahlungsreaktiver Vorstufen von Polyimiden, Polyisoindolochinazolindionen, Polyoxazindionen oder Polychinazolindionen, das dadurch gekennzeichnet ist, daß an carboxylgruppenhaltige Polyadditionsprodukte aus aromatischen und/oder heterocyclischen Tetracarbonsäuredianhydriden und Diaminoverbindungen oder an carboxylgruppenhaltige Polyadditionsprodukte aus aromatischen und/oder heterocyclischen Dihydroxydicarbonsäuren und Diisocyanaten oder an carboxylgruppenhaltige Polyadditionsprodukte aus aromatischen und/oder heterocyclischen Diaminodicarbonsäuren und Diisocyanaten ethylenisch ungesättigte Monoisocyanate addiert werden.

Als ethylenisch ungesättigte Monoisocyanate eignen sich insbesondere Verbindungen der allgemeinen Formel

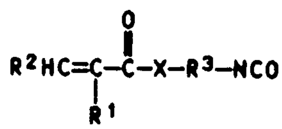

worin

$R^1$ für Wasserstoff oder einen Alkylrest mit 1 bis 5 Kohlenstoffatomen,

$R^2$ für Wasserstoff oder

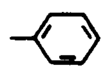 ,

$R^3$ für einen zweiwertigen Alkylenrest mit 1 bis 12 Kohlenstoffatomen, einen Cycloalkylenrest, einen Arylenrest oder einen Rest $-R^4-Y-R^5-$, wobei Y für O, S, $SO_2$, CO oder $NR^1$ steht und $R^4$ und $R^5$ untereinander gleich oder verschieden sind und für Alkylen- oder Arylenreste stehen, und die Alkylen-, Cycloalkylen- und Arylenreste auch halogen- oder alkylsubstituiert sein können,

X für O oder NH steht, Vinylisocyanat sowie Umsetzungsprodukte von Hydroxyalkyl-(meth)-acrylaten mit Diisocyanaten, wobei pro Hydroxylgruppe 1,8 bis 2,2 Isocyanatgruppen eingesetzt wurden, Umsetzungsprodukte von olefinisch ungesättigten Monoalkoholen mit Diisocyanaten, wobei pro Mol Hydroxylgruppe 1,8 bis 2,2 Isocyanatgruppen eingesetzt wurden, Umsetzungsprodukte von olefinisch ungesättigten Monocarbonsäuren mit Diisocyanat, wobei pro Carboxylgruppe 1,8 bis 2,2 Isocyanatgruppen eingesetzt wurden, Umsetzungsprodukte von ethylenisch ungesättigten Aminen mit Diisocyanaten, wobei pro Aminogruppe 1,8 bis 2,2 Isocyanatgruppen eingesetzt wurden, Umsetzungsprodukte von ethylenisch umgesättigten Amiden, N-Methylolamiden oder N-methylioletheramiden mit Diisocyanaten, wobei pro Stickstoff der Amide 1,8 bis 2,2 Isocyanatgruppen eingesetzt wurden Umsetzungsprodukte von ethylenisch ungesättigten Carbonsäureanhydriden mit Diisocyanaten, wobei pro Anhydridgruppe 1,8 bis 2,2 Isocyanatgruppen eingesetzt wurden, sowie Gemische derartiger ethylenisch ungesättigter Monoisocyanate.

Eine besonders vorteilhafte Arbeitsweise besteht auch darin, die als ethyungesättigte Monoisocyanate zu verwendenden Umsetzungsprodukte in Gegenwart der carboxylgruppenhaltigen Polyadditionsprodukte herzustellen.

Gegenstand der vorliegenden Erfindung ist auch die Verwendung der erfindungsgemäß hergestellten strahlungsreaktiven Vorstufe zur Herstellung von Kunststoffüberzügen für die Lichtleitfasern von Lichtwellenleitern und als strukturbildende Funktions- oder Hilfsschichten beim Aufbau elektronischer und/oder mikroelektronischer Bauelemente, nach vorheriger Belichtung unter einer Maske und nachfolgender Lösungsmittelstrukturierung.

Als besondere, nicht zu erwartende technische Vorteile der erfindungsgemäß hergestellten Vorstufen und deren Weiterverarbeitung bei ihrer Anwendung sind zu nennen, die technisch leichtere Einführung der Doppelbindungen in vorgefertigte carboxylgruppenhaltige Polyadditionsprodukte, wobei deren Molekulargewicht schon vorher festgelegt werden kann, und daß aufgrund der guten Reaktivität von Isocyanatgruppen mit den carboxylgruppenhaltigen Polyadditionsprodukten die Umsetzungen bei niedriger Temperatur durchgeführt werden können, wodurch Gelbildungen und Nebenreaktionen vermieden werden.

Weiter ist überraschend, daß die erfindungsgemäßen Stoffe beim Übergang von Zwischenstufe B in die Endstufe C einen geringeren Masseverlust aufweisen als erwartet wurde und dadurch eine bessere Strukturqualität erreicht wird.

Zum erfindungsgemäßen Verfahren und den hierzu zu verwendenden Aufbaukomponenten ist im einzelnen folgendes auszuführen.

Unter "Tetracarbonsäuredianhydrid" werden im Rahmen der vorliegenden Erfindung Verbindungen verstanden, die wenigstens zwei Säureanhydridgruppierungen aufweisen.

Der Begriff "Diaminoverbindungen" soll auch Verbindungen umfassen, die das Strukturelement >N-N< enthalten, d.h. Abkömmlinge des Hydrazins.

Unter "Diaminoverbindungen mit wenigstens einer ortho-ständigen Amidogruppe" werden Verbindungen verstanden, die wenigstens eine zu einer der beiden Aminogruppen der Diaminoverbindung orthoständigen Amidogruppe tragen.

Die erfindungsgemäß hergestellten oligomeren oder polymeren Polyimid-, Polyisoindolochinazolindion-, Polyoxazindion- und Polychinazolindion-Vorstufen sind strahlungsempfindlich und können somit leicht vernetzt werden; die vernetzten Produkte können dann durch thermische Behandlung in einfacher Weise in hochwärmebeständige Polyimide, Polyisoindolochinazolindione, Polyoxazindione und Polychinazolindione übergeführt werden. Diese Polymer-Vorstufen sind ferner in organischen Lösungsmitteln, insbesondere in polaren Lösungsmitteln, gut löslich. Aus wirtschaftlicher und ökologischer Sicht ist darüber hinaus wesentlich, daß die Vorstufen - aufgrund des Vorhandenseins von Hydroxylgruppen - zumindest teilweise in bzw. aus partiell wäßriger Lösung verarbeitet werden können.

Die erfindungsgemäßen Polymer-Vorstufen eignen sich insbesondere zur Herstellung von strukturierten hochwärmebeständigen Schutz- und Isolierschichten in der Mikroelektronik (Feinstrukturerzeugung) sowie zur Verwendung als Photoresist.

Für die erfindungsgemäß hergestellten strahlungsreaktiven Vorstufen kann im allgemeinen folgende Struktur angenommen werden:

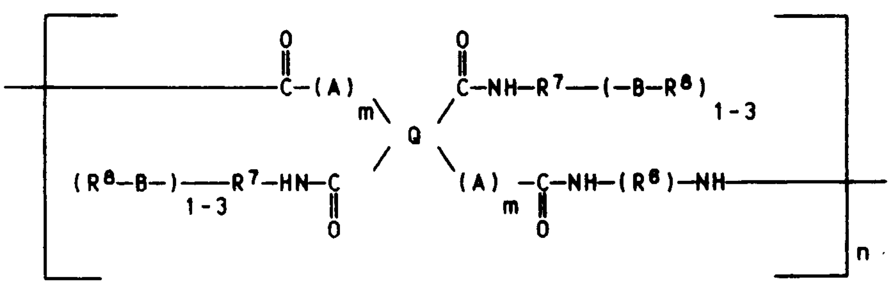

In dieser Formel 1 bedeutet n eine ganze Zahl von 2 bis 1000, bevorzugt 5 - 100.

- Q: ist ein - gegebenenfalls halogenierter - zumindest partiell aromatischer und/oder heterocyclischer tetravalenter, d.h. tetrafunktioneller Rest, bei dem jeweils zwei Valenzen in Nachbarstellung zueinander angeordnet sind; weist der Rest Q mehrere aromatische und/oder heterocyclische Strukturelemente auf, so befinden sich die Valenzpaare jeweils an endständigen derartigen Strukturelementen;
- $R^6$ ist ein - gegebenenfalls halogenierter - divalenter, d.h. difunktioneller Rest aliphatischer und/oder cycloaliphatischer, gegebenenfalls Heteroatome aufweisender, und/oder aromatischer und/oder heterocyclischer Struktur;
- $R^7$: ist ein polyfunktioneller Rest, bevorzugt difunktioneller Rest aliphatischer und/oder cycloaliphatischer und/oder aromatischer und/oder heterocyclischer Struktur;
- A: bedeutet -O- oder -NH-;
- m: ist 0 oder 1;
- B: ist ein Brückenglied, das aus der Reaktion von Isocyanatgruppen mit OH-Gruppen, Anhydridgruppen, Carboxylgruppen, sekundären oder primären Amingruppen, Amidgruppen oder Urethangruppen entstanden ist;
- $R^8$: ist ein olefinisch ungesättigter Rest.

Die erfindungsgemäßen strahlungsreaktiven Vorstufen sind also Additionsprodukte von olefinisch ungesättigten Isocyanaten an carboxylgruppenhaltige Prepolymere. Diese Prepolymere können sein:

- Polyadditionsprodukte von Tetracarbonsäuredianhydriden und Diaminoverbindungen (Polyimid-Prepolymere);

- Polyadditionsprodukte von Tetracarbonsäuredianhydriden und Diaminoverbindungen mit ortho-ständigen Amidogruppen (Polyisoindolochinazolindion-Prepolymere);
- Polyadditionsprodukte von Dihydroxydicarbonsäuren und Diisocyanaten (Polyoxazindion-Prepolymere); und
- Polyadditionsprodukte von Diaminodicarbonsäuren und Diisocyanaten (Polychinazolindion-Prepolymere).

Die bevorzugt eingesetzten Tetracarbonsäuredianhydride sind das Dianhydrid der Pyromellithsäure und der Benzophenontetracarbonsäure.

Als Diaminoverbindungen eignen sich übliche aromatische Diaminoverbindungen, bevorzugt ist der 4,4′-Diaminodiphenyläther. Bei den o-Aminoamiden ist das 4,4′-Diaminodiphenyl-3,3′-dicarbonsäureamid bevorzugt.

Als Dihydroxydicarbonsäure kann vorzugsweise die 4,4′-Dihydroxydiphenylmethan-3,3′-dicarbonsäure-(methylen-disalicylsäure), als Diaminodicarbonsäure die 4,4′-Diaminodiphenyl-3,3′-dicarbonsäure eingesetzt werden.

Als Diisocyanat ist das 4,4′-Diphenylmethandiisocyanat bevorzugt.

Erfindungemäß werden an die genannten carboxylgruppenhaltigen Prepolymeren ethylenisch ungesättigte Monoisocyanate addiert.

Erfindungsgemäß einzusetzende ethylenisch ungesättigte Monoisocyanate können folgender allgemeiner Formel entsprechen:

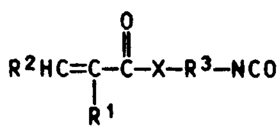

X = O oder NH,
$R^1$ = H oder $C_1$- bis $C_5$-Alkyl, insbesondere Methyl oder Ethyl
$R^2$ = H oder

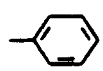 ,

$R^3$ = zweiwertiger Alkylenrest mit 1 bis 12 Kohlenstoffatomen, insbesondere Hexamethylen, ein Cycloalkylenrest, z.B. ein Cyclohexylenrest, ein Isophoronrest, ein Arylenrest, z.B. ein Phenylen-oder Naphthylenrest, oder ein Rest $-R^4-Y-R^5$, wobei
Y = -O-, -S-, -CO-, $SO_2$- oder $-NR^1-$; $R^4$ und $R^5$ untereinander gleich oder verschieden sind und für Alkylenreste mit 1 bis 6 Kohlenstoffatomen, Cycloalkylenreste, Arylenreste stehen und die Alkylen-, Cycloalkylen- und Arylenreste auch halogeniert sein können, oder $C_1$- bis $C_6$ alkylsubstituiert sein können.

Beispiele für derartige ethylensich ungesättigte Mono-Isocyanate sind

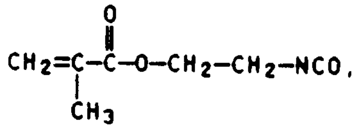

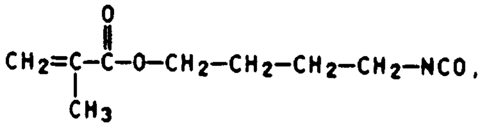

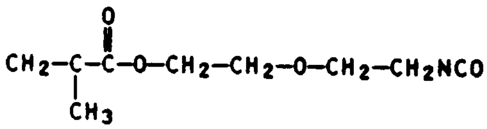

oder

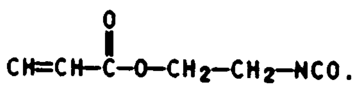

Als ethylenisch ungesättigte Monoisocyanate eignen sich außerdem Vinylisocyanat oder

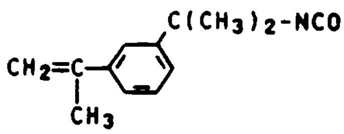

Weiter sind geeignete ungesättigte Monoisocyanate Umsetzungsprodukte, die durch die teilweise Umsetzung von polyfunktionellen Isocyanaten mit gegenüber Isocyanatgruppen reaktiven, olefinisch ungesättigten Verbindungen erhältlich sind. Die stöchiometrischen Verhältnisse werden dabei so gewählt, daß das polyfunktionelle Isocyanat rechnerisch im allgemeinen in einem solchen Überschuß vorhanden ist, daß eine NCO-Gruppe nicht umgesetzt wird. Von diesem Verhältnis kann auch abgewichen werden, z.B. kann ein geringerer Überschuß an Isocyanat Vernetzungen, Gelkörperbildung oder unerwünschte Viskositätserhöhung vermeiden. Bei Verwendung eines größeren Isocyanatüberschußes können höherviskose Vorstufen erhalten werden, die speziell für dickschichtige Anwendungen geeignet sein können.

Besonders gut geeignet und bevorzugt für die Umsetzung mit olefinisch ungesättigten, mit Isocyanatgruppen reaktiven Verbindungen, sind solche polyfunktionellen Isocyanate, deren Isocyanatgruppen verschieden stark reaktiv sind.

Technisch leicht zugängliche und besonders bevorzugte polyfunktionelle Isocyanate mit verschieden stark reaktiven Isocyanatgruppen sind beispielsweise Toluylendiisocyanat und Isophorondiisocyanat.

Erfindungemäß besonders bevorzugte ungesättigte Monoisocyanate sind Umsetzungsprodukte von polyfunktionellen Isocyanaten mit, mit Isocyanatgruppen reaktiven, ungesättigten Verbindungen und können z.B. erhalten werden aus:

2,4-Diisocyanatotoluol (2,4-TDI) und 3-Isocyanatomethyl-3,5,5-trimethyl-cyclohexylisocyanat (IPDI) mit Allylalkohol, Hydroxyethylacrylat, Hydroxalkyl-(meth)-acrylaten, wie Hydroxyethylmethacrylat, Hydroxypropylacrylat, Hydroxypropylmethacrylat, Butandiolmonoacrylat, Butandiolmonomethylacrylat, N-Hydroxymethylacrylamid, N-Hydroxymethylmethacrylamid, Diethylenglykolmonoacrylat, Diethylenglykolmonomethacrylat, Glycerindimethacrylat, Trimethylolpropandimethacrylat, Pentaerythrittrimethacrylat, dem äquimolaren Reaktionsprodukt von Glycidylmethacrylat mit einer organischen Säure, 2-Brom-allylalkohol, 3-Chlor-2-hydroxypropylmethacrylat, das äquimolare Reaktionsprodukt von Butylglycidylether mit Acrylsäure; ethylenisch ungesättigte Polyhydroxyverbindungen, wie Trimethylolpropanmonoacrylat, Pentaerythritdiacrylat, Pentaerythritmonoacrylat, Trimethylolpropan-monomethacrylat, Pentaerythritdimethacrylat, Pentaerythritmonomethacrylat, Zimtalkohol, Zimtsäure, Acrylsäure, Methacrylsäure, Ethylacrylsäure, Crotonsäure, Hydroxyalkylzimtsäureester, den Halbestern aus Zimtalkohol und Allylalkohol mit Dicarbonsäuren, den Halbestern von Zimtalkohol und Allylalkohol mit Maleinsäure, Dimethylmaleinsäure, (Meth)-Acrylamid, Zimtsäureamid, Allylamin, Dimethylmaleinsäureanhydrid, Maleinsäureanhydrid, Isopropylaminopropylmethacrylamid, Ether von Monoalkoholen mit N-Hydroxymethyl-(meth)-acrylamid.

Es können auch Gemische aus polyfunktionellen Isocyanaten mit Gemischen von mit Isocyanaten reaktionsfähigen olefinisch ungesättigten Verbindungen miteinander zur Reaktion gebracht und als ethylenisch ungesättigte Monoisocyanate eingesetzt werden.

Im Falle bifunktioneller Isocyanate und gegenüber Isocyanat monofunktioneller Verbindungen liegt dabei das Verhältnis der stöchiometrischen Äquivalenzen bei 2,2 bis 1,8 Äquivalent Isocyanatgruppen zu 1 Äquivalent mit Isocyanat reaktiven Gruppen, bevorzugt bei 2,0 bis 1,8, besonders bevorzugt bei 1,95 bis 1,8 zu 1.

Die Herstellung dieser Umsetzungsprodukte kann in Substanz oder in Lösemitteln durchgeführt werden. Dabei ist es zweckmäßig in solchen Lösemitteln zu arbeiten, die auch für die Herstellung der carboxylgruppenhaltigen Polyadditionsprodukte und für die spätere Verwendung der Vorstufen geeignet sind. Dies sind im allgemeinen polare Lösemittel, wie z.B. Formamid, Acetamid, N-Methylformamid, N,N-Dimethylformamid, N,N-Dimethylacetamid, Hexamethylphosphorsäuretriamid, N-Methylpyrrolidon.

Weiter ist es möglich, niedrigsiedende mit Isocyanat nicht reagierende, Lösemittel bei der Herstellung der Umsetzungsprodukte zu verwenden und diese in einem späteren Verfahrensschritt, z.B. bei der Umsetzung mit der carboxylgruppenhaltigen Vorstufe (PA), destillativ wieder zu entfernen, z.B. Methylethylketon, Methylisobutylketon, Ethylacetat, Propylacetat, Butylacetat, Cyclohexylacetat, Tetrahydrofuran, Dioxan, Diisopropylether, Diisobutylketon, Isophoron, Cyclohexanon, Benzol, Toluol und Xylol.

Diese Lösungsmittel können für sich allein oder in Mischung verwendet werden.

Erfindungsgemäß und besonders bevorzugt ist es auch, die Umsetzungsprodukte in situ, in Lösungen der Polyadditionsprodukte herzustellen und an diese weiter so zu addieren, daß die strahlungsreaktiven Vorstufen erhalten werden. Besonders geeignet für diese in situ-Fertigung sind Diisocyanate, deren Isocyanatgruppen unterschiedliche Reaktivität aufweisen, in Kombination mit ungesättigten Verbindungen, die mit Isocyanat leichter reagieren als die Carboxylgruppen der Polyadditionsprodukte. Ausführliche Angaben zu der Reaktivität von Isocyanatgruppen sind bei Vieweg/Höchtlen, Kunststoff-Handbuch Band VII "Polyurethane", Seiten 1 bis 39 gegeben.

Erfindungsgemäß besonders geeignet sind z.B. 2,4-Diisocyanatotoluol und 3-Isocyanatomethyl-3,5,5-trimethylcyclohexylisocyanat in Kombination mit Hydroxyalkyl-(meth)-acrylaten mit primären Hydroxygruppen, mit Allylalkohol oder Zimtalkohol.

Es ist besonders überraschend, daß bei diesem technisch einfach durchzuführenden Verfahren die Umsetzung sehr rasch und vollständig erfolgt, ohne daß dabei Vernetzungen oder Gelteile auftreten.

Es ist zweckmäßig, die Reaktion der Isocyanatgruppen bei den obengenannten Umsetzungen in an sich bekannter Weise zu katalysieren. Angaben über geeignete Katalysatoren für die Steuerung der Reaktion von Isocyanatgruppen mit anderen chemisch reaktiven Gruppen sind ebenfalls der Literatur, besonders auch dem obengenannten Handbuch "Polyurethane" zu entnehmen. Beispiele für geeignete Katalysatoren, die in Konzentrationen von ca. 0,01 bis 5% eingesetzt werden können, sind organisch lösliche Salze oder Komplexe von Metallen, wie Zinn, Zink, Eisen, Kupfer, Mangan, Nickel, Cobalt, Quecksilber oder Titan, z.B. Dibutylzinndilaurat, Kupferacetat, Manganoleat, Eisennaphthenat, Tetrabutyltitanat, weiter auch organische Verbindungen, insbesondere tertiäre Amine, wie z.B. Trialkylamine, Triarylamine, Tricycloalkylamine, gemischt substituierte Triamine, Dimethylaminopyridin, N-Methylpyrrolidin, N-Methylmorpholin, N-Methylpiperidin, Tetramethylethylendiamin, N,N'-Dimethylpiperazin oder Triethylendiamin. Es können auch Katalysatorgemische verwendet werden.

Weiter können Polymerisationsinhibitoren zugegeben werden, um eine thermische Polymerisation bei der Herstellung zu vermeiden. Solche Inhibitoren werden z.B. in Mengen von 0,001 bis 1% zugegeben. Geeignet sind z.B. Benzochinon, 2,5-Diphenyl-p-benzochinon, Hydrochinon, Hydrochinonmonomethylether, Catechin, $\alpha$-Naphthol, Mono-tert.-butylhydrochinon und Pyrogallol.

Anhand der Formeln 2 und 3 soll der mögliche Aufbau der erfindungsgemäß hergestellten Vorstufen A beispielhaft erläutert werden.

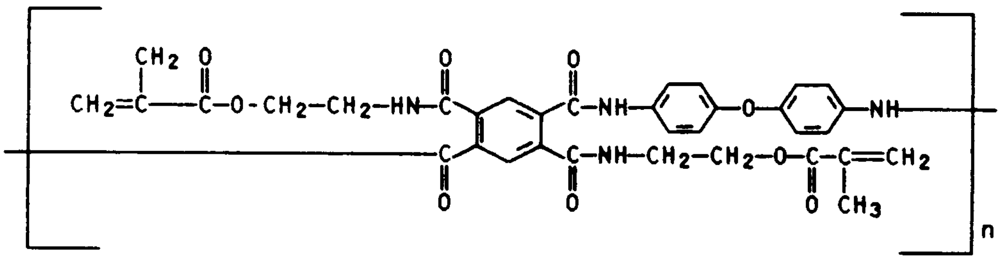

Formel 2

Formel 2 zeigt eine Vorstufe A, die bei der thermischen Nachbehandlung zu einem Polyimid führt. Sie ist aufgebaut aus Pyromellithsäuredianhydrid und 4,4′-Diaminodiphenylether, die in einem Verhältnis von etwa 1:1 miteinander umgesetzt werden und dabei die carboxylgruppenhaltige Vorstufe (PA) bilden. Diese wird dann mit Isocyanatoethylmethacrylat an den Carboxylgruppen weiter umgesetzt.

Weitere geeignete Aufbaustoffe anstelle oder in Mischung mit Pyromellitsäureanhydrid zu carboxylgruppenhaltigen Vorstufen (PA), die dem in Formel 2 beispielhaft dargestellten Aufbauprinzip entsprechen, sind z.B. die Anhydride.

2,3,9,10-Perylentetracarbonsäuredinahydrid, 1,4,5,8-Naphthalintetracarbonsäuredianhydrid, 2,6-Dichlornaphthalin-1,4,5,8-tetracarbonsäuredianhydrid, 2,7-Dichlornaphthalin-1,4,5,8-tetracarbonsäuredianhydrid, Phenanthren-1,8,9,10-tetracarbonsäuredianhydrid, Pyromellithsäuredianhydrid, 3,3′4,4′-Biphenyltetracarbonsäuredianhydrid, 2,2′,3,3′-Biphenyltetracarbonsäuredianhydrid, 4,4′-Isopropylidendiphthalsäureanhydrid, 3,3′-Isopro pylidendiphthalsäureanhydrid, 4,4′-Oxydiphthalsäureanhydrid, 4,4′-Sulfonyldiphthalsäureanhydrid, 3,3′-Oxydiphthalsäureanhydrid, 4,4′-Methylendiphthalsäureanhydrid, 4,4′-Thiodiphthalsäureanhydrid, 4,4′-Acetylidendiphthalsäureanhydrid, 2,3,6,7-Naphthalintetracarbonsäuredianhydrid, 1,2,4,5-Naphthalintetracarbonsäuredianhydrid, 1,2,5,6-Naphthalintetracarbonsäuredianhydrid, Benzol-1,2,3,4-tetracarbonsäuredianhydrid, Thiophen-2,3,4,5-tetracarbonsäuredianhydrid, 1-(3′,4′-Dicarboxyphenyl)-1,3,3-trimethylindan-5,6-dicarbonsäuredianhydrid, 1-(3′,4′-Dicarboxyphenyl)-1,3,3-trimethylindan-6,7-dicarbonsäuredianhydrid, 1-(3′,4′-Dicarboxyphenyl)-3-methylindan-5,6-dicarbonsäuredianhydrid, 1-(3′,4′-Dicarboxyphenyl)-3-methylindan-6,7-dicarbonsäuredianhydrid, 3,3′,4,4′-Benzophenontetracarbonsäureanhydrid, 4,5,3′,4′-Benzophenontetracarbonsäureanhydrid.

Diese Anhydride bilden in der Formel 1 den Rest Q.

An Stelle oder in Mischung mit 4,4-Diaminodiphenylether können auch andere Diamine eingesetzt werden, wobei das in Formel 2 beispielhaft angegebene Aufbauprinzip beibehalten wird. Solche Diamine sind z.B. 4,4-Methylenbis-(o-chloranilin), 3,3′-Dichlorbenzidin, 3,3′-Sulfonyldianilin, 4,4′-Diaminobenzophenon, 1,5-Diaminonaphthalin, Bis-(4-aminophenyl)-dimethylsilan, Bis-(4-aminophenyl)-diethylsilan, Bis-(4-aminophenyl)-diphenylsilan, Bis-(4-aminophenyloxy)-dimethylsilan, Bis-(4-aminophenyl)-ethylphosphinoxid, N-(Bis-(4-aminophenyl))-N-methylamin, N-(Bis-(4-aminophenyl))-N-phenylamin, 4,4′-Methylbis-(3-methylanilin), 4,4′-Methylenbis-(2-ethylanilin), 4,4′-Methylenbis-(2-methoxyanilin), 5,5′-Methylenbis-(2-aminophenol), 4,4′-Methylenbis-(2-methylanilin), 5,5′-Oxybis-(2-aminophenol), 4,4′-Thiobis-(2-methylanilin), 4,4′-Thiobis-(2-methoxyanilin), 4,4′-Thiobis-(2-chloranilin), 4,4′-Sulfonylbis-(2-ethoxyanilin), 4,4′-Sulfonylbis-(2-chloranilin), 5,5′-Sulfonylbis-(2-aminophenol), 3,3′-Dimethyl-4,4′-Diaminobenzophenon, 3,3′-Dimethoxy-4,4′-diaminobenzophenon, 3,3′-Dichlor-4,4′-diaminobenzophenon, 4,4′-Diaminobiphenyl, m-Phenylendiamin, p-Phenylendiamin, 4,4′-Methylendianilin, 4,4′-Oxydianilin, 4,4′-Thiodianilin, 4,4′-Sulfonyldianilin, 4,4′-Isopropylidendianilin, 3,3′-Dimethylbenzidin, 3,3′-Dimethoxybenzidin, 3,3′-Dicarboxybenzidin, Diaminotoluol.

Diese Diamine bilden gleichzeitig den in der Formel 1 mit $R^6$ bezeichneten Baustein.

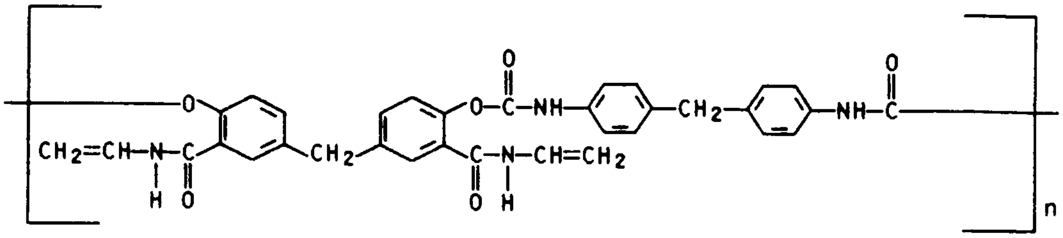

Formel 3

Formel 3 zeigt das Additionsprodukt von Vinylisocyanat an das Polyadditionsprodukt aus 3,3′-Dicarboxyl-4,4′-dihydroxydiphenylmethan und 4,4′-Diphenylmethandiisocyanat, d.h. eine strahlungsreaktive Polyoxazindion-Vorstufe, und zwar speziell eine Polybenzoxazindion-Vorstufe.

Die erfindungsgemäßen Vorstufen weisen als Grundbaustein für das Glied Q in Formel 1 bevorzugt aromatische Carbonsäuren auf und ergeben somit bei der thermischen Behandlung Polymere mit folgenden Struktureinheiten:

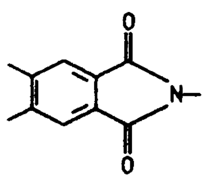

Polyimid

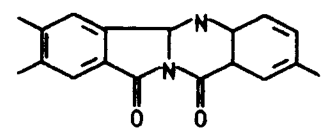

Polyisoindolochinazolindion

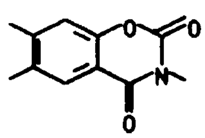

Polyoxazindion

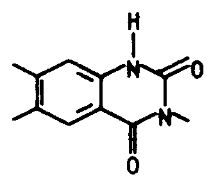

Polychinazolindion

Der Begriff "Polyimide" soll dabei auch Polyesterimide und Polyamidimide umfassen:

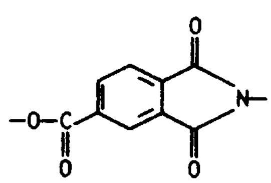

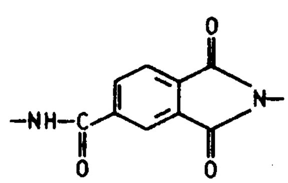

Die erfindungsgemäßen Polyimid-, Polyisoindolochinazolindion-, Polyoxazindion- und Polychinazolindion-Vorstufen werden vorteilhaft in der Weise hergestellt, daß ein aromatisches und/oder heterocyclisches Tetracarbonsäuredianhydrid mit einer Diaminoverbindung oder einer Diaminoverbindung mit wenigstens einer orthoständigen Amidogruppe bzw. eine aromatische und/oder heterocyclische Dihydroxydicarbonsäure oder eine entsprechende Diaminodicarbonsäure mit einem Diisocyanat zu einem carboxylgruppenhaltigen Reaktionsprodukt, d.h. einem Polyadditionsprodukt (PA) umgesetzt wird und das Reaktionsprodukt bei Raumtemperatur oder bei Temperaturen bis ca. 100 °C in einem organischen Lösungsmittel, gegebenenfalls in Gegenwart von Polymerisationsinhibitoren und/oder Katalysatoren für die Isocyanatreaktion mit einem olefinisch ungesättigten Monoisocyanat zur Reaktion gebracht wird.

Die primär gebildeten Polyadditionsprodukte (PA) können auch in situ mit einem polyfunktionellen

Isocyanat und einer gegen Isocyanatgruppen monofunktionell reaktiven, olefinisch ungesättigten Verbindung, gegebenenfalls in Gegenwart von Polymerisationsinhibitoren und/oder Katalysatoren für die Isocyanatreaktion umgesetzt werden.

Diese Reaktionen werden im allgemeinen bei Raumtemperatur oder bei Temperaturen unter 100°C durchgeführt, weil darüber bereits eine merkliche Cyclisierung eintritt und sich bei einem bestimmten Cyclisierungsgrad, der von den verwendeten Lösemittel und dem Aufbau der Stoffe abhängt, unlösliche Cyclisierungsprodukte bilden können.

Die Reaktionskontrolle erfolgt zweckmäßig durch IR-Spektroskopie, da Isocyanat und die Cyclisierungsprodukte sehr charakteristische Absorbtionsbanden erzeugen.

Vorteilhaft kann beim erfindungsgemäßen Verfahren das Tetracarbonsäuredianhydrid bei der Umsetzung mit der Diaminoverbindung, d.h. bei der Herstellung der Polyadditionsprodukte (PA) im Überschuß eingesetzt werden, wobei dann das erhaltene Reaktionsprodukt, eine Polyamidocarbonsäure, vor der Umsetzung mit dem olefinisch ungesättigten Isocyanat mit Hydroxyethylacrylat und/oder -methacrylat zur Reaktion gebracht wird oder das ungesättigte Isocyanat in einem äquivalenten Überschuß eingesetzt wird. Auf diese Weise werden die endständigen Säureanhydridgruppen abgefangen und Verbindungen mit klar definierter Struktur erhalten. Über das Abfangreagenz kann auch die Löslichkeit beeinflußt werden, insbesondere kann aber - aufgrund des ungesättigten Charakters dieser Komponente - eine erhöhte Empfindlichkeit der strahlungsreaktiven Vorstufen erreicht werden. Außer zur Verwendung als Photoresist und zur Herstellung von Schutz- und Isolierschichten, wobei eine Strukturierung erfolgt, können die erfindungsgemäßen Vorstufen auch allgemein - in nicht strukturierter Form - zur Herstellung von Schutz- und Isolierüberzügen dienen. Besonders vorteilhaft können diese Vorstufen dabei zur Herstellung von Kunststoffüberzügen für die Lichtleitfasern von Lichtwellenleitern verwendet werden.

Anhand von Ausführungsbeispielen soll die Erfindung noch näher erläutert werden.

Die in den folgenden Beispielen genannten Teile und Prozente sind, soweit nicht anders angegeben, Gewichtsteile bzw. Gewichtsprozente.

Herstellung eines Polyadditionsproduktes (PA):

109 Teile Pyromellithsäureanhydrid (0,5 Mol) werden bei 60°C unter Rühren in einem Reaktionskolben, der Druckausgleich über ein mit Trockenmittel gefülltes U-Rohr hat, unter reinstem Stickstoff in
486 Teilen N-Methylpyrrolidon gelöst. Über einen Tropftrichter wird eine Lösung von
100 Teilen Diaminodiphenylether in
350 Teilen N-Methylpyrrolidon in einer Stunde zugegeben, die Temperatur steigt auf 66°C an, es wird eine Stunde bei 75°C nachgerührt und dann abgekühlt. Das resultierende viskose Harz wird wie folgt charakterisiert.
SZ: 53,2
Viskosität: 5750 mPas bei einer Scherung von D = 100 $s^{-1}$
IR-Spektrum: typische Amidbandenkombination bei 1720, 1663, 1543, 1500 und 1240 $cm^{-1}$

Herstellung eines ungesättigten Isocyanats (Ia):

In einem Reaktionskolben werden unter reinstem Stickstoff
174 Teile 2,4-Toluylendiisocyanat (1 Mol/2 Äquivalent) gerührt, dazu wird eine Lösung von
116 Teilen Hydroxyethylacrylat (1 Mol/1 Äquivalent)
0,2 Teilen Triethylendiamin und
127 Teile n-Butylacetat in 3 Stunden zugetropft. Die Temperatur steigt dabei von 22°C auf 38°C an und fällt nach weiteren 3 Stunden auf Raumtemperatur. Es resultiert eine leicht gelbliche, niederviskose Flüssigkeit.
NCO-Gehalt: 5,7%.

Herstellung eines ungesättigten Isocyanats (Ib):

Es wird wie unter (Ia) verfahren, im Zulauf aber anstelle Hydroxyethylacrylat
129 Teile Zimtalkohol verwendet
NCO-Gehalt: 5,3%

Beispiel 1

Herstellung der strahlungsreaktiven Vorstufe:

200 g der Lösung des oben beschriebenen Polyadditionsproduktes (PA) und
0,1 g Triethylendiamin werden unter Rühren bei Raumtemperatur rasch mit
29 g Isocyanatoethylmethacrylat und
0,1 g Hydrochinonmonomethylether versetzt, die Apparatur wird verschlossen und mit einer Gaswaschflasche, die 10%ige Natronlauge enthält, verbunden und ein leichter Strom von hochreinem Stickstoff angelegt. Es wird auf 80 °C erwärmt, dabei tritt kräftige Gasentwicklung auf, die nach 35 Minuten aufhört. Es wird auf Raumtemperatur gekühlt. Die Gaswaschflasche hat eine Gewichtszunahme von 7,9 g. Es resultiert eine braune, klare, viskose Harzlösung, die im IR-Spektrum keine Isocyanatbande aufweist.

Beispiel 2

Es wird wie bei Beispiel 1 verfahren, aber anstelle von Isocyanatoethylmethacrylat werden
37 g der Verbindung

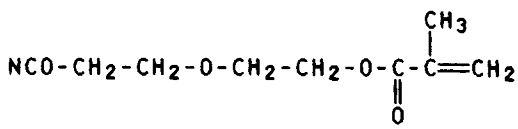

eingesetzt.
Es resultiert eine Harzlösung in der IR-spektroskopisch kein Isocyanat mehr nachweisbar ist.

Beispiel 3

Es wird wie bei Beispiel 1 verfahren, aber anstelle des dort eingesetzten ungesättigten Isocyanats, das Isocyanat (Ia) in einer Menge von
80 g eingesetzt.

Beispiel 4

Es wird wie in den Beispiel 1 verfahren, aber das Isocyanat (Ib) in einer Menge von
83 g eingesetzt.
Die gemäß den vorstehenden Beispielen hergestellten strahlungsreaktiven Vorstufen lassen sich nach Zusatz von Photoinitiatoren (z.B. Mischungen aus Michlers Keton und Benzophenon) auf Si-Waver aufschleudern, vortrocknen und nach Belichtung unter einer Maske mit Lösungsmittel strukturieren. Nach Erhitzen auf Temperaturen > 250 °C erhält man Strukturen der Endprodukte, die eine gute Ausbildung der Struktur mit hoher Kantenschärfe aufweisen.

## Patentansprüche

1. Verfahren zur Herstellung oligomerer oder polymerer strahlungsreaktiver Vorstufen von Polyimiden, Polyisoindolochinazolindionen, Polyoxazindionen oder Polychinazolindionen, dadurch gekennzeichnet daß an carboxylgruppenhaltige Polyadditionsprodukte aus aromatischen und/oder heterocyclischen Tetracarbonsäuredianhydriden und Diaminoverbindungen oder an carboxylgruppenhaltige Polyadditionsprodukte aus aromatischen und/oder heterocyclischen Dihydroxydicarbonsäuren und Diisocyanaten oder an carboxylgruppenhaltige Polyadditionsprodukte aus aromatischen und/oder heterocyclischen Diaminodicarbonsäuren und Diisocyanaten ethylenisch ungesättigte Monoisocyanate addiert werden.

2. Verfahren nach Anspruch 1, dadurch gekennzeichnet, daß als ethylenisch ungesättigte Monoisocyanate Verbindungen der allgemeinen Formel

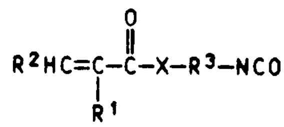

worin

$R^1$ für Wasserstoff oder einen Alkylrest mit 1 bis 5 Kohlenstoffatomen,

$R^2$ für Wasserstoff oder

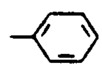,

$R^3$ für einen zweiwertigen Alkylenrest mit 1 bis 12 Kohlenstoffatomen, einen Cycloalkylenrest einen Arylenrest oder einen Rest $-R^4-Y-R^5-$, wobei Y für O, S, $SO_2$, CO oder $NR^1$ steht und $R^4$ und $R^5$ untereinander gleich oder verschieden sind und für Alkylen- oder Arylenreste stehen, und die Alkylen-, Cycloalky len- und Arylenreste auch halogen- oder alkylsubstituiert sein können, und

X für O oder NH steht,

eingesetzt werden.

**3.** Verfahren nach Anspruch 1, dadurch gekennzeichnet, daß als ethylenisch ungesättigte Monisocyanate Vinylisocyanat oder Umsetzungsprodukte von Hydroxyalkyl-(meth)-acrylaten mit Diisocyanaten, wobei pro Hydroxylgruppe 1,8 bis 2,2 Isocyanatgruppen eingesetzt wurde, verwendet werden.

**4.** Verfahren nach Anspruch 1, dadurch gekennzeichnet, daß alse thylenisch ungesattigte Monoisocyanate Umsetzungsprodukte von olefinisch ungesät tigten Monoaloholen mit Diisocyanaten, wobei pro Mol Hydroxylgruppe 1,8 bis 2,2 Isocyanantgruppen eingesetzt wurden, verwendet werden.

**5.** Verfahren nach Anspruch 1, dadurch gekennzeichnet, daß als ethylenisch ungesättigte Monoisocyanate Umsetzungsprodukte von olefinisch unge sättigten Monocarbonsäuren mit Diissocyanaten, wobei pro Carboxylgruppe 1,8 bis 2,2 Isocyanatgruppen eingestzt wurden, verwendet werden.

**6.** Verfahren nach Anspruch 1, dadurch gekennzeichnet, daß als ethylenisch ungesättgte Monoisocyanate Umsetzungsprodukte von ethylenisch ungesättigten Aminen mit Diisocyanaten, wobei pro Aminogruppe 1,8 bis 2,2 Isocyanatgruppen eingesetzt wurden, verwendet werden.

**7.** Verfahren nach Anspruch 1, dadurch gekennzeichnet, daß als ethlenisch ungesättigt Monoisocyanate Umsetzingsprodukte von ethlenisch unge sättigten Aminden, N-methylodlamiden oder N-methyloltheramiden mit Diisocyanaten, wobei pro Stickstoff der Amide 1,8 bis 2,2 Isocyanatguppen eingesetzt wurden, verwendet werden.

**8.** Verfahren nach Anspruch 1, dadurch gekennzeichnet, daß als ethylenisch ungesättigt Monisocyanate Umsetzungsprodukte von ethylenisch ungesättigten Carbonsäureahydriden mit Diiisocyanaten, wobei pro Anhydridgruppe 1,8 bis 2,2 Isocyanatgruppen eingesetzt wurden, verwendet werden.

**9.** Verfahren nach Anspruch 1, dadurch gekennzeicnet, daß als ethylenisch ungesättigte Monoisocyanate Gemische von zwei oder mehre Umsetzungsprodukten gemäß den Ansprüchen 3 bis 8 verwendet werden.

**10.** Verfahren nach Anspruch 1, dadurch gekennzeichnet, daß als ethylenisch ungesättigte Monoisocyanate Gemische von Verbindungen der allgemeinen Formel

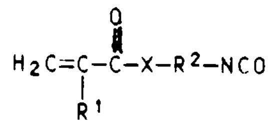

gemäß Anspruch 2 mit einem oder mehreren Umsetzungsprodukten gemäß den Ansprüchen 3 bis 8 verwendet werden.

**11.** Verfahren nach Anspruch 1, dadurch gekennzeichnet, daß die als ethylenisch ungesättigte Monoisocyanate zu verwendenden Umsetzungsprodukte nach einem der Ansprüche 3 bis 9 in Gegenwart der carboxylgruppenhaltigen Polyadditionsprodukte hergestellt werden.

**12.** Verfahren nach einem der vorhergehenden Ansprüche, dadurch gekennzeichnet, daß als Diisocyanate Toluylendiisocyanat, Isophorondiisocyanat oder Gemische dieser Diisocyanate eingesetzt werden.

**13.** Verfahren nach einem der vorhergehenden Ansprüche, dadurch gekennzeichnet, daß als aromatische und/oder heterocyclische Tetracarbonsäuredianhydride Pyromellithsäureanhydrid oder Benzophenontetracarbonsäureanhydrid eingesetzt werden.

**14.** Verfahren nach einem der vorhergehenden Ansprüche, dadurch gekennzeichnet, daß als Dihydroxydicarbonsäure 4,4′-Dihydroxydiphenylmethan-3,3′-dicarbonsäure eingesetzt wird.

**15.** Verfahren nach einem der vorhergehenden Ansprüche, dadurch gekennzeichnet, daß als Diaminodicarbonsäure 4,4′-Diaminodiphenyl-3,3′-dicarbonsäure eingesetzt wird.

**16.** Verfahren nach einem der vorhergehenden Ansprüche, dadurch gekennzeichnet, daß zur Herstellung der carboxylgruppenhaltigen Polyadditionsprodukte als Diisocyanat 4,4′-Diphenylmethandiisocyanat verwendet wird.

**17.** Verfahren nach Anspruch 1, dadurch gekennzeichnet, daß zur Herstellung der carboxylgruppenhaltigen Polyadditionsprodukte aromatisches und/oder heterocyclisches Tetracarbonsäuredianhydrid mit einer Diaminoverbindung oder einer Diaminoverbindung mit wenigstens einer ortho-ständigen Amidogruppe oder eine aromatische und/oder heterocyclische Dihydroxycarbonsäure oder eine entsprechende Diaminodicarbonsäure mit einem Diisocyanat zu einem carboxylgruppenhaltigen Reaktionsprodukt umgesetzt wird und das erhaltene Reaktionsprodukt bei Raumtemperatur oder bei Temperaturen bis etwa 100 °C in einem organischen Lösungsmittel, gegebenenfalls in Gegenwart eines Katalysators, mit einem olefinisch ungesättigten Monoisocyanat zur Reaktion gebracht wird.

**18.** Verfahren nach Anspruch 17, dadurch gekennzeichnet, daß das Tetracarbonsäureanhydrid bei der Umsetzung mit der Diaminoverbindung im Überschuß eingesetzt und das erhaltene Reaktionsprodukt vor der Umsetzung mit dem ethylenisch ungesättigten Isocyanat mit Hydroxyalkylacrylat und/oder -methacrylat zur Reaktion gebracht wird.

**19.** Verfahren zur Herstellung von Kunststoffüberzügen für die Lichtleitfasern von Lichtwellenleitern oder zur Herstellung von strukturbildenden Funktions- oder Hilfasschichten beim Aufbau elektronischer oder mikroelektronischer Bauelemente, nach vorheriger Belichtung unter einer Maske und nachfolgender Lösemittelstrukturiertung, dadurch gekennzeichnet,daß strahlungsreaktive Vorstufe, die nach einem Verfahren gemäß der Anprüche 1 bis hergestellt worden sind, eingesetzt werden.

## Claims

**1.** A process for the preparation of an oligomeric or polymeric radiation-reactive intermediate of a polyimide, polyisoindoloquinazolinedione, polyoxazinedione or polyquinazolinedione, wherein a carboxyl-containing polyadduct of an aromatic and/or heterocyclic tetracarboxylic dianhydride and a diamino compound, or a carboxyl-containing polyadduct of an aromatic and/or heterocyclic dihydroxydicarboxylic acid and a diisocyanate, or a carboxyl-containing polyadduct of an aromatic and/or heterocyclic diaminodicarboxylic acid and a diisocyanate is subjected to an addition reaction with an

ethylenically unsaturated monoisocyanate.

**2.** A process as claimed in claim 1, wherein the ethylenically unsaturated monoisocyanate used is a compound of the formula

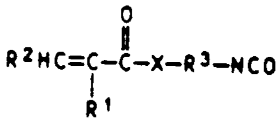

where $R^1$ is hydrogen or alkyl or 1 to 5 carbon atoms,
$R^2$ is hydrogen or

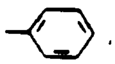

$R^3$ is a divalent alkylene radical of 1 to 12 carbon atoms, cycloalkylene, arylene or a radical $-R^4-Y-R^5-$, where Y is O, S, $SO_2$, CO or $NR^1$ and $R^4$ and $R^5$ are identical or different and are each alkylene or arylene, and the alkylene, cycloalkylene and arylene radicals may furthermore be halogen-substituted or alkyl-substituted,
and X is O or NH.

**3.** A process as claimed in claim 1, wherein the ethylenically unsaturated monoisocyanate used in vinyl isocyanate or a reaction product of a hydroxyalkyl (meth)acrylate with a diisocyanate, from 1.8 to 2.2 isocyanate groups being used per hydroxyl group.

**4.** A process as claimed in claim 1, wherein the ethylenically unsaturated monoisocyanate used is a reaction product of an olefinically unsaturated monoalcohol with a diisocyanate, from 1.8 to 2.2 diisocyanate groups being used per mole of hydroxyl groups.

**5.** A process as claimed in claim 1, wherein the ethylenically unsaturated monoisocyanate used is a reaction product of an olefinically unsaturated monocarboxylic acid with a diisocyanate, from 1.8 to 2.2 isocyanate groups being used per carboxyl group.

**6.** A process as claimed in claim 1, wherein the ethylenically unsaturated monoisocyanate used is a reaction product of an ethylenically unsaturated amine with a diisocyanate, from 1.8 to 2.2 isocyanate groups being used per amino group.

**7.** A process as claimed in claim 1, wherein the ethylenically unsaturated monoisocyanate used is a reaction product of an ethylenically unsaturated amide, an N-methylolamide or an N-methyloletheramide with a diisocyanate, from 1.8 to 2.2 isocyanate groups being used per nitrogen of the amide.

**8.** A process as claimed in claim 1, wherein the ethylenically unsaturated monoisocyanate used is a reaction product of an ethylenically unsaturated carboxylic anhydride with a diisocyanate, from 1.8 to 2.2 isocyanate groups being used per anhydride group.

**9.** A process as claimed in claim 1, wherein the ethylenically unsaturated monoisocyanate used is a mixture of two or more of the reaction products as claimed in any of claims 3 to 8.

**10.** A process as claimed in claim 1, wherein the ethylenically unsaturated monoisocyanate used is a mixture of compounds of the formula

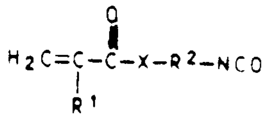

as claimed in claim 2 with one or more of the reaction products as claimed in any of claims 3 to 8.

**11.** A process as claimed in claim 1, wherein the reaction product to be used as the ethylenically unsaturated monoisocyanate as claimed in any of claims 3 to 9 is prepared in the presence of a carboxyl-containing polyadduct.

**12.** A process as claimed in any of the preceding claims, wherein the diisocyanate used is toluylene diisocyanate, isophorone diisocyanate or a mixture of these diisocyanates.

**13.** A process as claimed in any of the preceding claims, wherein the aromatic and/or heterocyclic tetracarboxylic dianhydride used is pyromellitic anhydride or benzophenonetetracarboxylic anhydride.

**14.** A process as claimed in any of the preceding claims, wherein the dihydroxydicarboxylic acid used is 4,4'-dihydroxydiphenylmethane-3,3'-dicarboxylic acid.

**15.** A process as claimed in any of the preceding claims, wherein the diaminodicarboxylic acid used is 4,4'-diaminodiphenyl-3,3'-dicarboxylic acid.

**16.** A process as claimed in any of the preceding claims, wherein 4,4'-diphenylmethane diisocyanate is used as the diisocyanate for the preparation of the carboxyl-containing polyadduct.

**17.** A process as claimed in claim 1, wherein, for the preparation of the carboxyl-containing polyadduct, an aromatic and/or heterocyclic tetracarboxylic dianhydride is reacted with a diamino compound or with a diamino compound having one or more ortho amido groups, or an aromatic and/or heterocyclic dihydroxycarboxylic acid or a corresponding diaminodicarboxylic acid is reacted with a diisocyanate to give a carboxyl-containing reaction product, and the resulting reaction product is reacted with an olefinically unsaturated monoisocyanate at room temperature or at up to about 100 ° C in an organic solvent in the presence or absence of a catalyst.

**18.** A process as claimed in claim 17, wherein the tetracarboxylic anhydride is used in excess in the reaction with the diamino compound, and the resulting reaction product is reacted with a hydroxyalkyl acrylate and/or methacrylate before the reaction with the ethylenically unsaturated isocyanate.

**19.** A process for the production of a plastic coating for the optical fibers of optical waveguides or for the production of structure-forming functional or auxiliary layers in the construction of electronic or microelectronic components, after prior exposure under a mask followed by solvent structuring, wherein a radiation-reactive intermediate prepared by a process as claimed in any of claims 1 to 18 is used.

## Revendications

**1.** Procédé de préparation de stades préliminaires réactifs par rayonnement oligomères ou polymères, de polyimides, polyiso-indoloquinazolinediones, polyoxazindiones ou polyquinazolindiones, caractérisé par le fait que l'on fixe par addition des monoisocyanates à insaturation éthylénique sur des produits de polyaddition contenant des groupes carboxyle, à base de dianhydrides tétracarboxyliques aromatiques et/ou hétérocycliques et de composés diaminés, ou sur des produits de polyaddition contenant des groupes carboxyle, à base d'acides dihydroxydicarboxyliques aromatiques et/ou hétérocycliques et de diisocyanates, ou sur des produits de poly-addition contenant des groupes carboxyle, à base d'acides diaminodicarboxyliques aromatiques et/ou hétérocycliques et de diisocyanates.

**2.** Procédé selon la revendication 1, caractérisé par le fait que l'on utilise, comme mono-isocyanates à insaturation éthylénique, des composés de formule générale

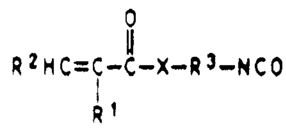

où
$R^1$ est mis pour hydrogène ou un reste alkyle ayant 1 à 5 atomes de carbone,
$R^2$ pour hydrogène ou

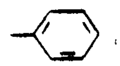

$R^3$ pour un reste alkylène/bivalent à 1 à 12 atomes de carbone,
un reste cycloalkylène,
un reste arylène ou
un reste $-R^4-Y-R^5-$, Y étant mis pour O, S, $SO_2$, CO ou $NR^1$ et
$R^4$ et $R^5$ étant différents ou identiques et représentant des restes alkylène ou arylène, les restes alkylène, cycloalkylène et arylène pouvant aussi être substitués par halogène ou alkyle,
X pour O ou NH.

**3.** Procédé selon la revendication 1, caractérisé par le fait que l'on utilise, comme mono-isocyanates à insaturation éthylénique, du vinylisocyanate ou des produits de réaction d'hydroxyalkyl-(méth)-acrylates avec des diisocyanates en calculant, par groupe hydroxyle, 1,8 à 2,2 groupes isocyanate.

**4.** Procédé selon la revendication 1, caractérisé par le fait que l'on utilise, comme mono-isocyanates à insaturation éthylénique, des produits de réaction de mono-alcools à insaturation oléfinique avec des diisocyanates en calculant, par mole de groupe hydroxyle, 1,8 à 2,2 groupes isocyanate.

**5.** Procédé selon la revendication 1, caractérisé par le fait que l'on utilise, comme mono-isocyanates à insaturation éthylénique, des produits de réaction d'acides monocarbocyliques à insaturation oléfinique avec des diisocyanates, en calculant, par groupe carboxyle, 1,8 à 2,2 groupes isocyanate.

**6.** Procédé selon la revendication 1, caractérisé par le fait que l'on utilise, comme mono-isocyanates à insaturation éthylénique, des produits de réaction d'amines à insaturation éthylénique avec des diisocyanates, en calculant, par groupe amino, 1,8 à 2,2 groupes isocyanate.

**7.** Procédé selon la revendication 1, caractérisé par le fait que l'on utilise, comme mono-isocyanates à insaturation éthylénique, des produits de réaction d'amides, N-méthylolamides ou N-méthyloléthers-amides à insaturation éthylénique avec des diisocyanates, en calculant, par atome d'azote des amides, 1,8 à 2,2 groupes isocyanate.

**8.** Procédé selon la revendication 1, caractérisé par le fait que l'on utilise, comme mono-isocyanates à insaturation éthylénique, des produits de réaction d'anhydrides carbocyliques à insaturation éthylénique avec des diisocyanate, en calculant, par groupe anhydride, 1,8 à 2,2 groupes isocyanate.

**9.** Procédé selon la revendication 1, caractérisé par le fait que l'on utilise, comme mono-isocyanates à insaturation éthylénique, des mélanges de deux ou plus de deux produits de réaction selon les revendications 3 à 8.

**10.** Procédé selon la revendication 1, caractérisé par le fait que l'on utilise, comme mono-isocyanates à insaturation éthylénique, des mélanges de composés de formule générale

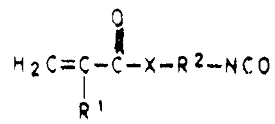

selon la revendication 2, avec un ou plusieurs produits de réaction selon les revendications 3 à 8.

**11.** Procédé selon la revendication 1, caractérisé par le fait que les produits de réaction à utiliser comme monoisocyanates à insaturation éthylénique sont préparés selon l'une des revendications 3 à 9, en présence des produits de polyaddition contenant des groupes carboxyle.

**12.** Procédé selon l'une des revendications précédentes, caractérisé par le fait que l'on utilise, comme diisocyanates, le toluylènediisocyanate, l'isophoronediisocyanate ou des mélanges desdits diisocyanates.

**13.** Procédé selon l'une des revendications précédentes, caractérisé par le fait que l'on utilise, comme dianhydrides tétracarboxyliques aromatiques et/ou hétérocycliques, l'anhydride pyromellique ou l'anhydride benzophénone-tétracarboxylique.

**14.** Procédé selon l'une des revendications précédentes, caractérisé par le fait que l'on utilise, comme acide dihydroxydicarboxylique, l'acide 4,4'-dihydroxydiphénylméthane-3,3'-dicarboxylique.

**15.** Procédé selon l'une des revendications précédentes, caractérisé par le fait que l'on utilise, comme acide diaminodicarboxylique, l'acide 4-4'-diaminodiphényl-3,3'-dicarboxylique.

**16.** Procédé selon l'une des revendications précédentes, caractérisé par le fait que l'on utilise comme diisocyanate pour la préparation de produits de polyaddition contenant des groupes carboxyle, le 4,4'-diphénylméthanediisocyanate.

**17.** Procédé selon la revendication 1, caractérisé par le fait que l'on fait réagir, en vue de la préparation des produits de polyaddition contenant des groupes carboxyle, du dianhydride tétracarboxylique aromatique et/ou hétérocyclique avec un composé diaminé ou avec un composé diaminé portant au moins un groupe amido en position ortho, ou on fait réagir un acide dihydroxycarboxylique aromatique et/ou hétérocyclique ou un acide diaminodicarboxylique correspondant avec un diisocyanate, pour obtenir un produit de réaction contenant des groupes carboxyle et on met à réagir le produit de réaction ainsi obtenu, à température ordinaire ou à des températures allant jusqu'à environ 100 degrés C, dans un solvant organique, éventuellement en présence d'un catalyseur, avec un mono-isocyanate à insaturation oléfinique.

**18.** Procédé selon la revendication 17, caractérisé par le fait que l'anhydride tétracarboxylique, lors de la réaction avec le composé diaminé, est utilisé en excès, et le produit de réaction obtenu est mis à réagir, avant réaction avec l'isocyanate à insaturation éthylénique, avec de l'hydroxyalkylacrylate et/ou-méthacrylate.

**19.** Procédé de préparation de revêtements en matière plastique pour les fibres photo-conductrices de conducteurs d'ondes lumineuses ou pour la confection de couches structurales fonctionnelles ou auxiliaires lors de la composition d'éléments de constructions électroniques ou micro-électroniques, après exposition à la lumière et structuration subséquente par un solvant, caractérisé par le fait que l'on utilise des stades préliminaires réactifs par rayonnement qui ont été préparés par un procédé selon l'une des revendications 1 à 18.